# EUROPÄISCHE PATENTSCHRIFT

(11) **EP 1 468 233 B1**
(45) Veröffentlichungstag und Bekanntmachung des Hinweises auf die Patenterteilung: **23.03.2011**
(21) Anmeldenummer: 02722031.8
(22) Anmeldetag: 24.01.2002
(51) Int. Cl.: F27B 17/00, F27D 11/02, H05B 3/62

(54) **WIDERSTANDSOFEN**
RESISTANCE FURNACE
FOUR A RESISTANCE

(43) Veröffentlichungstag der Anmeldung: 20.10.2004
(73) Patentinhaber: Heraeus Quarzglas GmbH & Co. KG, 63450 Hanau (DE)
(72) Erfinder: BOGDAHN, Thomas, 63791 Karlstein (DE); GANZ, Oliver, 63486 Bruchköbel (DE)
(74) Vertreter: Staudt, Armin Walter
(86) Internationale Anmeldenummer: PCT/EP2002/000663
(87) Internationale Veröffentlichungsnummer: WO 2003/062727

(56) Entgegenhaltungen:
- FR-A- 500 555
- US-A- 2 121 744
- US-A- 3 139 474
- US-A- 4 549 345

## Beschreibung

Die vorliegende Erfindung betrifft einen Widerstandsofen, umfassend ein rohrförmiges Heizelement mit vertikal orientierter Längsachse, das eine von einer Oberseite und einer Unterseite begrenzte Mantelfläche aufweist, die einen Ofenraum umgibt, und das mit mindestens zwei Stromanschlüssen verbunden ist, mittels denen an Strom-Einspeisungsstellen Heizstrom in das Heizelement eingeleitet wird, wobei die Stromanschlüsse eine im Bereich der Oberseite umlaufende, obere Ringmanschette und eine im Bereich der Unterseite umlaufende, untere Ringmanschette aufweisen.

Mit Hilfe von Widerstandsöfen lassen sich hohe Temperaturen erreichen. Dabei fließt ein elektrischer Strom durch einen als Heizleiter ausgebildeten Ohm'schen Widerstand, wobei die elektrische Leistung größtenteils in Wärme umgewandelt wird. Als Werkstoff für die Heizleiter kommen zum Beispiel Metalle wie Molybdän, Tantal und Platin, Keramik, SiC oder Modifikationen von Kohlenstoff, wie Kohle, Graphit oder glasartiger Kohlenstoff (pyrolytisch erzeugter Kohlenstoff) in Betracht. Heizleiter aus Graphit zeichnen sich durch hohe Temperaturbeständigkeit, einfache Formgebung und günstigen Preis aus.

Widerstandsöfen werden beispielsweise zum Erschmelzen von Halbleitermaterial eingesetzt, oder zum Erhitzen von stab- oder rohrfömigem Ausgangszylindern, um daraus Rohre, Stäbe oder optische Fasern zu elongieren. Abgesehen von Sonderfällen, bei denen eine gezielt inhomogene Heizleistung gewünscht wird (etwa beim Ziehen von Zylindern mit polygonalem Querschnitt), liegt das Hauptaugenmerk regelmäßig auf einem gleichmäßigen Erhitzen des Heizguts.

Die lokale Heizleistung ist direkt proportional zur Stromdichte, wobei diese durch den Stromfluss und die Querschnittsfläche und den spezifischen Widerstand des Heizleiter-Werkstoffs bestimmt wird. Der spezifische Widerstand hängt wiederum von der lokalen Temperatur ab. Die relativ geringe Leitfähigkeit der Heizleiterwerkstoffe und der damit einhergehende Spannungsabfall erschwert die Erzeugung und Aufrechterhaltung eines homogenen Temperaturprofils.

Daher wird in der US-A 4,703,556 ein Ofen mit einem Graphit-Heizrohr vorgeschlagen, bei dem über den Umfang des Heizrohres mehrere axial verlaufende Längsschlitze verteilt sind, die sich abwechselnd von oben und von unten bis fast über die gesamte Heizrohr-Höhe erstrecken. Die verbleibenden Stege des Heizrohres werden somit mäanderförmig elektrisch durchströmt. Dadurch wird eine Homogenisierung des Temperaturverlaufs in vertikaler Richtung erreicht.

Eine weitere Homogenisierung der Stromdichte innerhalb des Heizrohres wird erreicht, indem für die Zufuhr des Heizstroms zwei Graphit-Anschlussstücke vorgesehen sind, die im Bereich der Unterseite des Heizrohres an sich gegenüberliegenden Stellen angeschraubt sind und die über getrennte Transformatoren gespeist werden. Durch die zweite Strom-Einspeisungsstelle kann dem Spannungsabfall über der Gesamtlänge der Heizrohr-Stege entgegengewirkt werden, so dass eine verbesserte vertikale und horizontale Homogenität der Strom- und Temperaturverteilung erreicht wird.

Die Herstellung des bekannten Heizrohres ist sehr jedoch aufwendig. Aufgrund seiner filigranen Form ist es anfällig gegenüber mechanischer Beschädigung und muss daher häufig ausgetauscht werden. Zudem kann es durch Verzunderung und Oxidation im Bereich der Stromanschlüsse zu einer Verschlechterung des elektrischen Kontakts und zu einer undefinierten Stromzufuhr und damit zu einer ungleichmäßigen Beheizung und Temperaturverteilung über dem Heizrohr kommen. Diese Gefahr wird dadurch verstärkt, dass sich die Stromanschlüsse in unmittelbarer Nähe der Zone mit maximaler Temperaturbelastung befinden.

Bei Widerstandsöfen mit hoher Leistung (oberhalb ca. 100 kW) machen sich Temperatursenken besonders bemerkbar und erschweren zunehmend die Einstellung und Einhaltung einer homogenen Temperaturverteilung.

Ein widerstandsbeheizter Hochtemperaturofen der eingangs genannten Gattung ist in der US-A-3,139,474 beschrieben. Innerhalb einer gasdichten Einhausung ist ein rohrförmiges Widerstands-Heizelement angeordnet, dessen Enden mit metallischen Manschetten für den Stromanschluss versehen sind. Im unteren Bereich der Einhausung ist ein Anschluss für zwei Pumpen und eine Inertgasquelle vorgesehen. Über diesen Anschluss kann der Innenraum der Einhausung evakuiert oder mit Inertgas gefüllt werden.

Der bekannte Hochtemperaturofen ist für einen Betrieb mit beidseitig oder einseitig offenem Ofen-Innenraum nicht ausgelegt. Es bestünde die Gefahr, dass Fremdluft in den Ofenraum eintritt, durch die das Heizgut oder das Heizelement beschädigt werden, und die einen Temperaturgradienten innerhalb des Ofenraums erzeugt, was die Einstellung eines homogenen axialen oder radialen Temperaturprofils erschwert.

Der Erfindung liegt die Aufgabe zugrunde, einen elektrischen Widerstandsofen, insbesondere einen Widerstandsöfen mit hoher Leistung, anzugeben, der sich durch geringen Fertigungs- und Wartungsaufwand sowie hohe Betriebssicherheit auszeichnet, und der auch bei einseitig oder beidseitig offenem Ofen die reproduzierbare Einstellung eines axial und radial homogenen Temperaturprofils innerhalb des Ofens ermöglicht.

Diese Aufgabe wird ausgehend von dem eingangs genannten Widerstandsofen erfindungsgemäß dadurch gelöst, dass eine Einrichtung für eine Gasspülung vorgesehen ist, die einen Gaseinlass aufweist, der in mindestens einer Verzweigungsstufe in mehrere Nebenleitungen verzweigt, wobei die Nebenleitungen in einer Vielzahl von Gasauslässen münden, die gleichmäßig um einen Hüllkreis verteilt und in den Ofenraum gerichtet sind.

Über die Ringmanschetten wird der Heizstrom in das Heizelement eingeleitet. Hierzu ist eine Ringmanschette am oberen stirnseitigen Ende und eine Ringmanschette am unteren stirnseitigen Ende des Heizelements vorgesehen. Die Ringmanschetten sind mit der jeweiligen Stirnseite des rohrförmigen Heizelements, mit dem Innenmantel und/oder mit dem Außenmantel in Kontakt, wobei der Kontaktbereich vorzugsweise flächig ausgebildet ist - im einfachsten Fall als ringförmige Kontaktfläche zwischen Ringmanschette und Heizelement. Die Ringmanschetten sind aus einem Stück gefertigt oder sie sind aus Einzelteilen zusammengesetzt.

Für das Einspeisen des Heizstroms in die jeweilige Ringmanschette weisen diese jeweils mindestens einen Stromanschluss auf. Der mindestens eine Stromanschluss der Ringmanschetten wird im Folgenden auch als "Elektrodenanschluss" bezeichnet.

Als Heizelement wird hier dasjenige Bauteil des Widerstandsofens verstanden, dem der Heizstrom zugeführt wird. Es kann einstückig ausgebildet oder aus mehreren Teilen zusammengesetzt sein.

Die Ringmanschetten bestehen aus einem Metall mit guter elektrischer Leitfähigkeit, so dass sich - über deren Umfang gesehen - ein möglichst geringer horizontaler Spannungsabfall einstellt. Da die Ringmanschetten sowohl an der Oberseite als auch an der Unterseite des Heizelements vorgesehen sind und damit die Stromzufuhr zum Heizelement von zwei Seiten aus erfolgt, ergibt sich auch über die Höhe des Heizelements ein geringerer vertikaler Spannungsabfall im Vergleich zu einer Stromzufuhr von nur einer Seite aus. Somit wird eine insgesamt verbesserte Homogenität der Strom- und Temperaturverteilung erzielt.

Für die Einleitung eines Gasstroms in das Heizelement ist eine Einrichtung für eine Gasspülung vorgesehen, die einen Gaseinlass aufweist, der in mindestens zwei Nebenleitungen verzweigt, und diese münden wiederum in eine Vielzahl von Gasauslässen, die gleichmäßig um einen Hüllkreis verteilt sind und die den Ofenraum gerichtet sind. Die Gasauslässe bilden zusammen eine Gasdusche mit im Wesentlichen ringförmigem Querschnitt. Die Gasströmung durchströmt das Heizelement in axialer Richtung (in Richtung der vertikalen Längsachse). Die beschriebene Gasdusche ist für den Einsatz in Verbindung mit einem erfindungsgemäßen Widerstandsofen ebenso geeignet, wie für den Einsatz in Verbindung mit einem Induktionsofen.

Insbesondere im Hinblick auf eine homogene, horizontale Verteilung der Strom-Leistungsdichte innerhalb des Heizelements hat es sich bewährt, dass jede Ringmanschette einen Elektrodenanschluss für die Einspeisung des Heizstroms aufweist, wobei - in Umfangsrichtung gesehen - der Elektrodenanschluss der oberen Ringmanschette versetzt zu dem Elektrodenanschluss der unteren Ringmanschette angeordnet ist.

Bei nur einem Elektrodenanschluss ergibt sich die höchste Leistungsdichte innerhalb der jeweiligen Ringmanschette stets im Bereich des Elektrodenanschlusses und die geringste Leistungsdichte in der Regel auf der am weitesten entfernten Seite der Ringmanschette. Um dies zu kompensieren hat es sich als günstig erwiesen, jede Ringmanschette mit mindestens zwei um die Ringmanschette in Umfangsrichtung gleichmäßig verteilten Elektrodenanschlüssen zu versehen. Vorteilhafterweise sind dabei die Elektrodenanschlüsse um den Umfang der Ringmanschette gleichmäßig verteilt. unmittelbarer Nähe eines Elektrodenanschlusses (auch wenn die Ringmanschette mit mehreren Elektrodenanschlüssen versehen ist). Um dies zu kompensieren sind bei einer besonders bevorzugten Ausführungsform des Widerstandsofens in der Ringmanschette Bereiche geringerer elektrischer Leitfähigkeit ausgebildet, mittels denen der eingespeiste Heizstrom in mindestens vier, vorzugsweise in mindestens acht Strombahnen verzweigt wird, die zu um den Umfang des Heizelements gleichmäßig verteilten, begünstigten Strom-Einspeisungsstellen führen.

Als "Strombahn" wird hier der Weg verstanden, den der Heizstroms vom Elektrodenanschluss zu dem Kontaktbereich am Heizelement zurücklegt. Je kürzer eine Strombahn ist, umso höher ist die Stromdichte im Kontaktbereich.

Angestrebt wird aber eine möglichst gleichmäßige Stromdichte an der umlaufenden Kontaktfläche zwischen Ringmanschette und Heizelement. Dies wird erfindungsgemäß durch einmaliges oder mehrmalige Verzweigung des in die Ringmanschette eingespeisten Heizstroms erreicht, so dass sich mindestens vier Strombahnen ausbilden. Die Verzweigung wird durch Bereiche erreicht, die eine geringere elektrische Leitfähigkeit als das restliche Material der Ringmanschette aufweisen. Aufrund der geringeren Leitfähigkeit (die auch Null betragen kann), umfließt der Strom diese Bereiche im Wesentlichen, so dass sich eine Aufteilung und Zwangsführung für den Stromflusses realisieren lässt. So gelingt es beispielsweise durch radial verlaufende Längsschlitze in der Ringmanschette, den "kürzesten Weg" vom jeweiligen Elektrodenanschluss zum Kontaktbereich zu unterbrechen. Im Idealfall weisen die vier oder mehr Strombahnen gleiche Länge auf. Der Bereich, in dem die jeweilige Strombahn endet wird hier als "begünstigte Strom-Einspeisungsstelle" bezeichnet. Die hohe elektrische Leitfähigkeit der Ringmanschette bewirkt in jedem Fall eine in erster Näherung gleichmäßige, horizontale Verteilung des Heizstroms um die Bereiche geringerer elektrischer Leitfähigkeit herum. Als "begünstigte Strom-Einspeisungsstelle" wird derjenige flächige Kontaktbereich zum Heizelement bezeichnet, der unter Berücksichtigung der Zwangsführung über die Strombahnen einen vergleichsweise kurzen Abstand zum Elektrodenanschluss und demzufolge trotz näherungsweise gleichmäßiger Stromdichte-Verteilung eine immer noch höhere Stromdichte aufweist. Eine Ausführungsform mit vier begünstigten Strom-Einspeisungsstellen wird im Folgenden auch als "4-Punkteinspeisung" bezeichnet, und entsprechend eine Ausführungsform mit acht begünstigten Strom-Einspeisungsstellen als "8-Punkteinspeisung".

Durch eine gleichmäßige Verteilung von begünstigten Strom-Einspeisungsstellen um den Umfang des Heizelements wird eine gleichmäßige radiale Stromdichte-Verteilung um das Heizelement erreicht, was zusätzlich zur Verbesserung der Homogenität der Strom- und Temperaturverteilung beiträgt. Diese Maßnahme macht sich insbesondere bei hohen Heizleistungen (oberhalb von 100 kW) positiv bemerkbar.

Besonders bewährt hat sich eine Ausführungsform des erfindungsgemäßen Widerstandsofens, bei der - in Umfangsrichtung gesehen - die begünstigten Strom-Einspeisungsstellen der oberen Ringmanschette versetzt zu den Strom-Einspeisungsstellen der unteren Ringmanschette angeordnet sind. Durch den Versatz der unteren zu den oberen Strom-Einspeisungsstellen kann eine weitere vertikale (axiale) Homogenisierung des Leistungsdichteverlaufs und damit eine bessere Temperaturhomogenität erzielt werden. Der Versatz zwischen den Strom-Einspeisungsstellen der oberen und unteren Ringmanschette erfolgt üblicherweise so, dass sich in Bezug auf die Längsachse des Heizrohres eine Rotationssymmetrie ergibt.

Vorteilhafterweise sind die Ringmanschetten mit einem Anschlusskonus versehen, der mit einem konischen Anschlussbereich des Heizelements korrespondiert. Durch den Konus ergibt sich eine Selbstzentrierung von Ringmanschette und Heizrohr und eine feste Fixierung, so dass Änderungen des Kontaktwiderstandes beim Einsatz des Ofens vermieden werden. Die Ringmanschette ist einstückig ausgebildet oder sie ist aus mehreren Bauteilen zusammengesetzt. Insbesondere kann der Anschlusskonus als separates Bauteil gefertigt sein. Eine günstigere Kräfteverteilung ergibt sich, wenn der Anschlusskonus jeweils als Innenkonus und der Anschlussbereich des Heizelements als Außenkonus ausgebildet sind. Die Ringmanschetten sitzen dabei mit dem Anschlusskonus auf dem Außenkonus des Heizelements auf.

Vorzugsweise sind die Ringmanschetten mit einem ersten umlaufenden Kühlkanal, der einen ersten Kühlmittel-Einlass aufweist, versehen. Durch die Kühlung kann die Temperatur der Ringmanschetten und damit der spezifische ohm'sche Widerstand örtlich und zeitlich konstant gehalten werden.

Im Hinblick hierauf hat es sich als besonders vorteilhaft erwiesen, wenn die Ringmanschetten benachbart zum ersten Kühlkanal und räumlich getrennt von diesem einen zweiten umlaufenden Kühlkanal mit einem zweiten Kühlmittel-Einlass aufweisen, wobei der zweite Einlass - in Umfangsrichtung gesehen - auf der dem ersten Einlass gegenüberliegenden Seite der Ringmanschette angeordnet ist. Durch die beiden Kühlkanäle ist eine Kühlung im Gegenstrom möglich, was zu einer weiteren Homogenisierung der horizontalen Temperaturverteilung über den Ringmanschetten beiträgt.

Bei einer Ringmanschette, die - wie oben erläutert - mit einem Anschlusskonus versehen sind, ist der Kühlkanal bzw. sind die Kühlkanäle vorzugsweise im Bereich des Anschlusskonus ausgebildet. Es ist nicht erforderlich, dass dieser Bereich von demjenigen Bereich der Ringmanschette, in dem der Heizstrom in die Strombahnen verzweigt, elektrisch isoliert ist.

Aufgrund seiner hohen elektrischen Leitfähigkeit kommen bevorzugt Ringmanschetten aus Kupfer oder aus einer Kupferlegierung zum Einsatz. Die hohe Leitfähigkeit bewirkt einen geringen Spannungsabfall, was die Einhaltung einer homogenen Verteilung der Strom- und Leistungsdichte innerhalb der Ringmanschetten und damit auch im Kontaktbereich zum Heizrohr erleichtert.

Es wird eine Ausführungsform des erfindungsgemäßen Widerstandsofens bevorzugt, bei der das Heizelement ein Heizrohr mit einer dünneren Wandstärke umfasst, das beidseitig mittels mindestens einem sich stirnseitig anschließenden Kontaktrohr mit einer dickeren Wandstärke verlängert ist, wobei die Ringmanschetten jeweils an dem Kontaktrohr anliegen.

Bei dieser bevorzugten Ausgestaltung des erfindungsgemäßen Widerstandsofens ist zwischen dem eigentlichen Heizrohr und den Ringmanschetten ein Kontaktrohr vorgesehen. Im Bereich des dünnwandigen Heizrohres stellt sich die höchste Temperatur ein, während das Kontaktrohr aufgrund seiner dickeren Wandstärke weniger aufgeheizt wird und dadurch auch die Ringmanschetten einer geringeren Temperaturbelastung unterliegen. Dadurch ist die Gefahr einer Veränderung des Kontaktwiderstandes durch Verzunderung oder Oxidation verringert. Das Heizrohr und die sich daran anschließenden Kontaktrohre sind in der Regel als separate Bauteile ausgebildet. Die Kontaktrohre können einteilig ausgebildet oder aus mehreren Einzelteilen zusammengesetzt sein. Wesentlich ist, dass die Temperatur im Bereich der Kontaktrohre geringer ist als die Temperatur im Bereich des Heizrohres. Hierfür können die Kontaktrohre anstelle einer dickeren Wandstärke auch aus einem Material mit geringerem spezifischen Widerstand als das Heizrohr ausgebildet sein. Die Ausbildung des Heizelements mit Kontaktrohren trägt zur Eignung des erfindungsgemäßen Widerstandsofens für einen Einsatz bei hohen Heizleistungen wesentlich bei.

Eine weitere Verbesserung hinsichtlich der Homogenität der Temperaturverteilung ergibt sich, wenn eine Spanneinrichtung vorgesehen ist, die mehrere Spannelemente umfasst, mittels denen die Kontaktrohre, das Heizrohr und die Ringmanschetten in axialer Richtung gegeneinander verspannt werden. Die Spanneinrichtung gewährleistet einen gleichbleibenden elektrischen Kontakt zwischen den jeweiligen Teilen und minimiert lokale Änderungen des Kontaktwiderstandes. Als Spannelemente sind vorzugsweise mindestens vier um den Umfang des Heizelements gleichmäßig verteilte Zuganker vorgesehen. Die rotationssymmetrische Anordnung der Zuganker (um die Heizelement-Längsachse) trägt zu einer symmetrischen Stromdichte- und Temperaturverteilung im Heizelement bei. Die Zuganker weisen zum Beispiel eine Feder mit exakter Federkonstante auf, über die eine gleichbleibende Vorspannung reproduzierbar und nachprüfbar eingestellt werden kann.

Es hat sich als besonders günstig erwiesen, wenn der Gaseinlass in mindestens drei Verzweigungsstufen mit gleichem Druckverlust verzweigt.

Der Gaseinlass verzweigt in mindestens drei Nebenleitungen, und diese münden wiederum in eine Vielzahl von Gasauslässen, die gleichmäßig um einen Hüllkreis verteilt sind und die den Ofenraum gerichtet sind. Die Gasauslässe bilden zusammen eine Gasdusche mit im Wesentlichen ringförmigem Querschnitt. Die Gasströmung durchströmt das Heizelement in axialer Richtung (in Richtung der vertikalen Längsachse). Um eine möglichst homogene und laminare Gasströmung zu erhalten, sollte der an den Gasauslässen anliegende Gasdruck möglichst gleich sein. Dies wird erreicht, wenn der durch die Nebenleitungen bewirkte Druckverlust möglichst gleich ist. Der Druckverlust wird durch den Strömungsquerschnitt und durch die Weglänge des Gases zwischen Gaseinlass und Mündung der jeweiligen Nebenleitung bestimmt. Die Strömungsquerschnitte und die Weglängen der Nebenleitungen sind somit idealerweise identisch. Je größer die Anzahl der Verzweigungen ist, umso homogener ist die ringförmige Gasspülung realisierbar. Allerdings nimmt mit der Anzahl der Verzweigungen auch der Fertigungsaufwand zu. Ein optimaler Kompromiss ergibt sich bei drei Verzweigungen. Im Hinblick hierauf hat es sich besonders bewährt, die Gasauslässe in einem oberhalb der oberen Ringmanschette angeordneten Spülring auszubilden, der sich aus mindestens zwei - vorzugsweise aus mindestens vier - separaten Kreissegmenten zusammensetzt, wobei die Nebenleitungen jeweils in eines der Kreissegmente münden. Vier Kreissegmente ergeben sich durch zweimaliges Verzweigen des Gaseinlasses in zunächst zwei und dann vier Nebenleitungen. Die Nebenleitungen münden vorzugsweise mittig in je eines der Kreissegmente, wodurch sich eine weitere Verzweigung des Gasstroms ergibt. Die den Spülring bildenden Segmente liegen auf dem oben erwähnten Hüllkreis. Der vor den Gasauslässen anliegende Gasdruck innerhalb der Kreissegmente ist weitgehend gleich, wobei dies infolge der Verzweigungen darauf zurückzuführen ist, dass das Spülgas vom Gaseinlass bis zu den Gasauslässen annähernd gleiche Wege zurücklegt. Eine bevorzugte Ausgestaltung des erfindungsgemäßen Widerstandsofens zeichnet sich dadurch aus, dass das Heizelement von einem temperierbaren Schutzmantel umgeben ist, an dessen Außenwandung Kühlplatten lösbar befestigt sind, innerhalb denen eine Kühlflüssigkeit fließt.

An der Außenwandung des Schutzmantels sind Kühlplatten lösbar befestigt, innerhalb denen eine Kühlflüssigkeit fließt. Die Kühlplatten sind entweder mit einer separaten Versorgung für die Kühlflüssigkeit verbunden; es können auch mehrere Kühlplatten hinsichtlich der Versorgung mit Kühlflüssigkeit in Reihe oder parallel geschaltet sein. Mittels der Kühlplatten kann auch die Temperaturverteilung innerhalb des Heizelements Einfluss genommen werden, wobei auch eine lokal unterschiedliche Temperierung des Schutzmantels möglich ist. Die lösbare Verbindung der Kühlplatten mit dem Schutzmantel gewährleistet einen einfachen Austausch.

Es hat sich als günstig erwiesen, das Innere des Heizelements mittels Quarzwolle nach außen abzudichten. Quarzwolle zeichnet sich durch hohe Temperaturbeständigkeit aus. In dem Fall, dass der Widerstandsofen zum Erhitzen von Quarzglaskörpern eingesetzt wird, handelt es sich bei Quarzwolle um artgleiches Material. Quarzwolle kann vorab einer Reinigung, beispielsweise durch chemisches Ätzen oder durch Heißchlorieren, unterzogen werden. Eine weitere Verbesserung ergibt sich, wenn die Quarzwolle aus synthetisch hergestelltem SiO₂ besteht.

Die Erfindung wird nachfolgend anhand eines Ausführungsbeispiels und einer Zeichnung näher erläutert. In der Zeichnung zeigen in schematischer Darstellung im Einzelnen:
- **Figur 1**: eine Ausführungsform eines Widerstandsofen gemäß der Erfindung in einer Seitenansicht,
- **Figur 2**: eine Ausführungsform einer Ringmanschette zur Einspeisung von Heizstrom in ein Heizrohr mittels 8-Punkt-Einspeisung in einer Draufsicht, und
- **Figur 3**: eine Ausführungsform eines Spülrings zur Erzeugung eines laminaren ringspaltförmigen Spülgasstroms in einer Draufsicht.

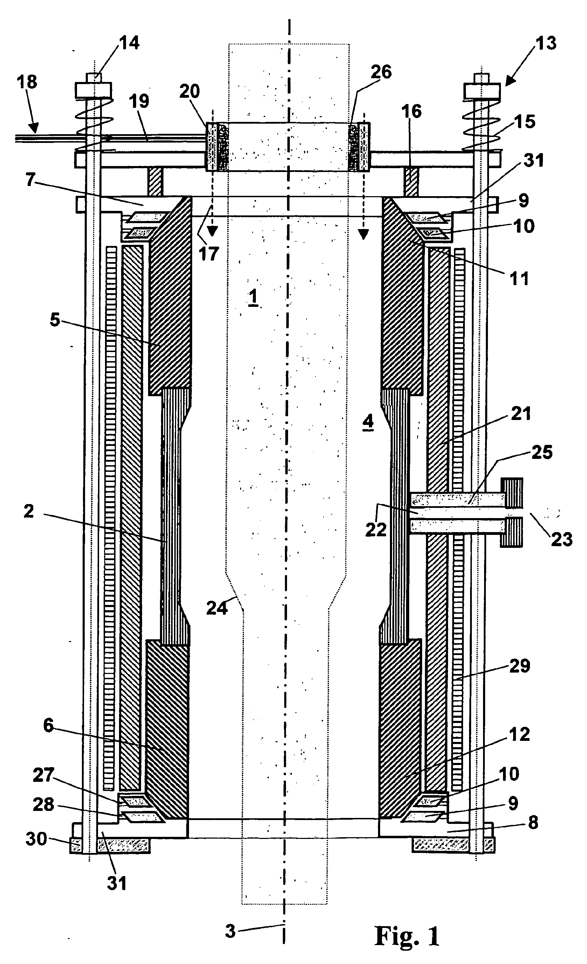

Der in **Figur 1** dargestellte Widerstandsofen gemäß der Erfindung wird zum Erwärmen und Elongieren eines Zylinders 1 aus Quarzglas eingesetzt. Es handelt sich dabei um einen Hochleistungsofen mit einer maximalen Heizleistung von 700 kW. Der Widerstandsofen weist ein Heizrohr 2 aus Graphit mit vertikal orientierter Längsachse 3 auf, das einen Heizraum 4 umschließt.

An dem Heizrohr 2 liegen beiderseits stirnseitig Kontaktrohre 5; 6 an. Die Kontaktrohre 5; 6 bestehen ebenfalls aus Graphit und sie weisen eine größere Wandstärke als das Heizrohr 2 auf.

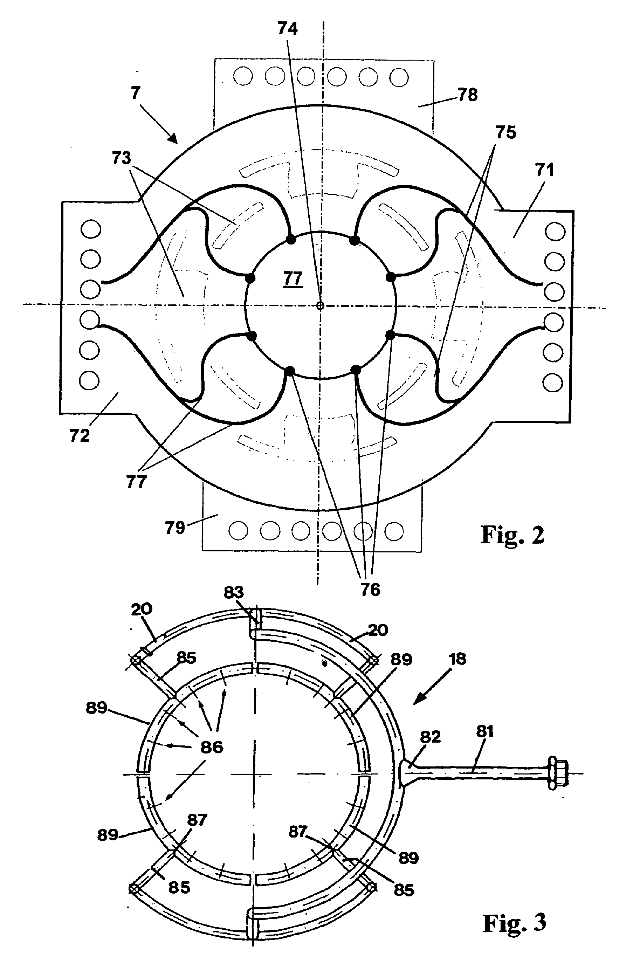

Das Einleiten des Heizstroms in das Heizrohr 2 erfolgt über Ringmanschetten 7; 8 aus einer Kupferlegierung CuCrZr, wobei eine obere Ringmanschette 7 an der Oberseite 11 des oberen Kontaktrohres 5 und eine untere Ringmanschette 8 an der Unterseite 12 des unteren Kontaktrohres 6 anliegen. Die Ringmanschetten 7; 8 weisen nach außen ragende Flansche 31 auf, in denen Durchgangsbohrungen vorgesehen sind, die sich jeweils radial über einen Teil des Umfangs der Ringmanschetten 7;8 erstrecken, und mittels denen der den Ringmanschetten 7; 8 zugeführte Heizstrom in acht etwa gleich lange Strombahnen verzweigt wird, so dass eine 8-Punkteinspeisung erreicht wird. Die Form und Funktionsweise der Ringmanschetten 7; 8 im Hinblick hierauf werden weiter unten anhand Figur 2 näher beschrieben.

Jede der Ringmanschetten 7; 8 ist mit zwei zueinander benachbart verlaufenden, umlaufenden Kühlkanälen 9; 10 versehen, durch die zur Kühlung der Ringmanschetten 7; 8 Wasser im Gegenstrom geführt wird. Durch die Wasserkühlung wird die Temperatur der Ringmanschetten 7; 8 und damit der spezifische Widerstand örtlich und zeitlich konstant gehalten. Der Kühlwasser-Einlass 27 des einen Kühlkanals 9 liegt dabei dem Kühlwasser-Einlass 28 des anderen Kühlkanals 10 gegenüber. Durch die beiden Kühlkanäle 9; 10 ist eine Kühlung der Ringmanschetten 7; 8 im Gegenstrom möglich, was zu einer weiteren Homogenisierung der horizontalen Temperaturverteilung über den Ringmanschetten 7; 8 beiträgt.

Zur Fixierung der Ringmanschetten 7; 8 an den Kontaktrohren 5; 6 sind Oberseite 11 des oberen Kontaktrohres 5 und Unterseite 12 des unteren Kontaktrohres 6 mit einem umlaufenden Außenkonus versehen, der mit einem Innenkonus der jeweilig zugeordneten Ringmanschette 7; 8 korrespondiert.

Heizrohr 2, Kontaktrohre 5; 6 und Ringmanschetten 7, 8 sind mittels einer Spannvorrichtung 13 gegeneinander verspannt. Die Spannvorrichtung 13 umfasst vier um den Umfang des Heizrohres 2 gleichmäßig verteilte, mit einer Bodenplatte 30 verbundene Zuganker 14. Diese weisen jeweils eine einstellbare Spannfeder 15 mit definierter Federkonstante auf, mittels denen über Abstandhalter 16 die genannten Ofenteile (2; 5; 6; 7; 8) mit vorgegebener und messbarer Druckkraft aufeinander gepresst werden, wobei die rotationssymmetrische Verteilung der Zuganker 14 auch eine Symmetrie der Druckspannungsverteilung bewirkt, was sich auf die homogene Verteilung der Stromdichte und Temperatur innerhalb des Heizrohres günstig auswirkt.

Zur Einleitung eines Spülgasstroms (Richtungspfeile 17) in den Ofenraum 4 ist oberhalb der oberen Ringmanschette 7 ein Spülgasring 18 angeordnet, der um seinen Umfang mit Gasauslässen versehen ist, die in den Ofenraum 4 gerichtet sind. Der Spülgasring 18 besteht aus vier separaten Kreissegmenten, in die jeweils eine aus einem Gaseinlass 19 verzweigte Nebenleitung 20 einmündet. Details zu Konstruktion und Funktionsweise des Spülgasrings 18 werden weiter unten anhand Figur 3 beschrieben.

Zur Hitzeabschirmung sind das Heizrohr 2 und die Kontaktrohre 5; 6 von einem temperierbaren Ofenmantel 21 umgeben, an dessen Außenmantel segmentweise Kühlplatten 29 angeschraubt sind. Die Kühlplatten 29 werden von einer Kühlflüssigkeit durchströmt, wobei die Kühlkreisläufe der Kühlplatten 29 voneinander getrennt sind, so dass eine lokal unterschiedliche Temperierung des Ofenmantels ermöglicht wird. Um den Abzug von Wärme aus dem Ofenraum 4 zu vermindern, ist zwischen den Kühlplatten 29 und dem Ofenmantel 21 ein Spalt 30 vorgesehen, so dass die Kühlplatten 29 nicht unmittelbar an dem Ofenmantel 21 anliegen.

Der Ofenmantel 21 weist mittig eine Durchgangsbohrung 22 auf, durch die mittels eines Lichtwellenleiters 23 die Temperatur des Heizrohres 2 gemessen wird. Mittels des Lichtwellenleiters 23 wird das Temperatur-Messsignal zu einem Messgerät übertragen. Das Messgerät kann dadurch vom Heizrohr 2 so weit entfernt, dass eine Kühlung zum Schutz des Messgeräts nicht erforderlich ist.

Der Spalt zwischen den Nebenleitungen 20 des Spülrings 18 und dem Quarzglas-Zylinder 1 ist mittels gereinigter Quarzwolle 26 abgedichtet.

Figur 2 zeigt in schematischer Darstellung die obere Ringmanschette 7 in einer Draufsicht. Die Ringmanschette 7 besteht aus einem im Wesentlichen ringförmigen Kupferscheibe, die mit zwei sich am Außenumfang gegenüberliegenden Elektrodenanschlüsse 71; 72 (Anschlussfahnen) versehen ist, über die der Heizstrom in die Ringmanschette 7 eingespeist wird. Die Elektrodenanschlüsse 71; 72 werden von einer gemeinsamen Stromquelle (In der Figur nicht dagestellt) gespeist. Die Ringmanschette 7 ist mit mehreren Durchgangsöffnungen 73 versehen, die radial um einen Teil des Umfangs - verlaufen und die um die Mittelachse 74 (entspricht der Längsachse 3) symmetrisch verteilt sind. Die Durchgangsöffnungen 73 sind dabei im Bereich des Flansches 30 ausgebildet und so angeordnet, dass der von den Elektrodenanschlüssen 71; 72 eingespeiste Heizstrom in acht gleich langen Strombahnen - durch Richtungspfeile 75 symbolisiert - verzweigt und so zu "begünstigten Einspeisungsstellen" 76 im Bereich der Innenbohrung 77 gelenkt wird, mit der die Ringmanschette 7 an dem Kontaktrohr 5 (siehe Figur 1) anliegt. Durch die beiden Elektrodenanschlüsse 71, 72 und durch die Verteilung und Größe der Durchgangsöffnungen 73 erfolgt bei der Ringmanschette 7 gemäß

Figur 2 eine Verteilung des Heizstroms auf insgesamt acht begünstigte Einspeisungsstellen 76 ("8-Punkteinspeisung"). Dies führt im Vergleich zu einer Ausführungsform der Ringmanschette mit nur einer "begünstigten Einspeisungsstelle" zu einer gleichmäßigeren Stromdichteverteilung im Bereich der Innenbohrung 77 und damit zu einer homogenen, horizontalen Verteilung der Stromdichte im Bereich des Kontaktrohres 5 und damit auch des Heizrohres 2.

Eine weitere Homogenisierung der Stromdichteverteilung im Heizrohr 2 wird erreicht, indem die Elektrodenanschlüsse 71; 72 der oberen Ringmanschette 7 um 90 Grad versetzt zu den Elektrodenanschlüssen 78; 79 der unteren Ringmanschette 8 (siehe Figur 1) angeordnet sind, wie dies in Figur 2 schematisch angedeutet ist. Die untere Ringmanschette 8 ist ebenfalls in Richtung einer "8-Punkteinspeisung" des Heizstroms optimiert, so dass sich durch die versetzte Anordnung der Ringmanschetten 7; 8 auch ein Versatz der "begünstigten Strom-Einspeisungsstellen" um 90 Grad sowie in Bezug auf die Mittelachse 74 eine Rotationssymmetrie ergibt. Hierdurch wird eine gleichmäßige vertikale Stromdichte-Verteilung im Heizrohr 2 erreicht, was zusätzlich zur Verbesserung der Homogenität der Strom- und Temperaturverteilung beiträgt.

Um einen Einbruch von Sauerstoff in den Ofenraum 4 zu vermeiden, wird dieser während des Ziehprozesses mit Stickstoff gespült. Hierzu wird ein Spülring 18 (Figur 1) eingesetzt, wie er in Figur 3 dargestellt ist. Der Spülring 18 besteht aus miteinander verbundenen Kupferrohren, die einen Gaseinlassstutzen 81 bilden, der in zwei Verzweigungsstufen 82; 83 in insgesamt vier Nebenleitungen 20 verzweigt. Die Nebenleitungen 20 münden jeweils - unter Bildung einer dritten Verzweigungsstufe 85 - mittig in ein Ringsegment 89, das mit mehreren Gasauslässen 86 versehen ist. Die Gasauslässe 86 der Ringsegmente 89 liegen auf einem Hüllkreis der kleiner ist als der innendurchmesser des Heizrohres 2. Die Gasauslässe 86 bilden zusammen eine Gasdusche mit im Wesentlichen ringförmigem Querschnitt. Die von den Gasauslässen 86 ausgehende Stickstoffströmung durchströmt das Heizrohr 2 in Richtung der Längsachse 3 von oben nach unten. Um eine möglichst homogene und laminare Stickstoffströmung zu erhalten, wird ein möglichst gleicher Gasdruck an den Gasauslässen 86 angestrebt. Dies wird dadurch erreicht, dass alle Nebenleitungen 20 gleiche Länge und den gleichen Innendurchmesser aufweisen und dass für alle Nebenleitungen 20 der Abstand zwischen der ersten Verzweigungsstufe 82 und der Mündung 87 in das jeweilige Ringsegment 89 gleich lang ist.

## Patentansprüche

1. Widerstandsofen, umfassend ein rohrförmiges Heizelement mit vertikal orientierter Längsachse, das eine von einer Oberseite und einer Unterseite begrenzte Mantelfläche aufweist, die einen Ofenraum umgibt, und das mit mindestens zwei Stromanschlüssen verbunden ist, mittels denen an Strom-Einspeisungsstellen Heizstrom in das Heizelement eingeleitet wird, wobei die Stromanschlüsse eine im Bereich der Oberseite (11) umlaufende, obere Ringmanschette (7) und eine im Bereich der Unterseite (12) umlaufende, untere Ringmanschette (8) aufweisen, **dadurch gekennzeichnet, dass** eine Einrichtung für eine Gasspülung vorgesehen ist, die einen Gaseinlass (19) aufweist, der in mindestens einer Verzweigungsstufe (82) in mehrere Nebenleitungen (20) verzweigt, wobei die Nebenleitungen (20) in einer Vielzahl von Gasauslässen (86) münden, die gleichmäßig um einen Hüllkreis verteilt und in den Ofenraum (4) gerichtet sind.

2. Widerstandsofen nach Anspruch 1, **dadurch gekennzeichnet, dass** jede Ringmanschette (7; 8) einen Elektrodenanschluss (71) für die Einspeisung des Heizstroms aufweist, und dass - in Umfangsrichtung gesehen - der Elektrodenanschluss (71) der oberen Ringmanschette (7) versetzt zu dem Elektrodenanschluss der unteren Ringmanschette (8) angeordnet ist.

3. Widerstandsofen nach Anspruch 1 oder 2, **dadurch gekennzeichnet, dass** jede Ringmanschette (7; 8) mit mindestens zwei um die Ringmanschette (7; 8) in Umfangsrichtung gleichmäßig verteilten Elektrodenanschlüssen (71; 72) versehen ist.

4. Widerstandsofen nach einem der vorhergehenden Ansprüche, **dadurch gekennzeichnet, dass** in der Ringmanschette (7; 8) Bereiche (73) geringerer elektrischer Leitfähigkeit ausgebildet sind, mittels denen der eingespeiste Heizstrom in mindestens vier, vorzugsweise in mindestens acht Strombahnen (77) verzweigt wird, die zu um den Umfang des Heizelements (2; 5; 6) gleichmäßig verteilten, begünstigten Strom-Einspeisungsstellen (76) führen.

5. Widerstandsofen nach Anspruch 4, **dadurch gekennzeichnet, dass** - in Umfangsrichtung gesehen - die Strom-Einspeisungsstellen (76) der oberen Ringmanschette (7) versetzt zu den Strom-Einspeisungsstellen der unteren Ringmanschette (8) angeordnet ist.

6. Widerstandsofen nach einem der vorhergehenden Ansprüche, **dadurch gekennzeichnet, dass** die Ringmanschetten (7; 8) einen Anschlusskonus aufweisen, der mit einem konischen Anschlussbereich des Heizelements (2; 5; 6) korrespondiert.

7. Widerstandsofen nach Anspruch 6, **dadurch gekennzeichnet, dass** der Anschlusskonus als Innenkonus und der Anschlussbereich des Heizelements (2; 5; 6) als Außenkonus ausgebildet sind.

8. Widerstandsofen nach einem der vorhergehenden Ansprüche, **dadurch gekennzeichnet, dass** die Ringmanschetten (7; 8) einen ersten umlaufenden Kühlkanal (9) aufweisen, der mit einem ersten Kühlmittel-Einlass (27) versehen ist.

9. Widerstandsofen nach Anspruch 8, **dadurch gekennzeichnet, dass** die Ringmanschetten (7; 8) benachbart zum ersten Kühlkanal (9) und räumlich getrennt von diesem einen zweiten umlaufenden Kühlkanal (10) mit einem zweiten Kühlmittel-Einlass (28) aufweisen, wobei der zweite Einlass (28) - in Umfangsrichtung gesehen - auf der dem ersten Einlass (27) gegenüberliegenden Seite der Ringmanschette (7; 8) angeordnet ist.

10. Widerstandsofen nach einem der vorhergehenden Ansprüche, **dadurch gekennzeichnet, dass** die Ringmanschetten (7; 8) aus Kupfer oder aus einer Kupferlegierung bestehen.

11. Widerstandsofen nach einem der vorhergehenden Ansprüche, **dadurch gekennzeichnet, dass** das Heizelement (2; 5; 6) ein Heizrohr (2) mit einer dünneren Wandstärke umfasst, das beidseitig mittels mindestens einem sich stirnseitig anschließenden Kontaktrohr (5; 6) mit einer dickeren Wandstärke verlängert ist, wobei die Ringmanschetten (7; 8) jeweils an dem Kontaktrohr (5; 6) anliegen.

12. Widerstandsofen nach Anspruch 11, **dadurch gekennzeichnet, dass** eine Spanneinrichtung vorgesehen ist, die mehrere Spannelemente (13) umfasst, mittels denen die Kontaktrohre (5; 6), das Heizrohr (2) und die Ringmanschetten (7; 8) in axialer Richtung gegeneinander verspannt werden.

13. Widerstandsofen nach Anspruch 12, **dadurch gekennzeichnet, dass** als Spannelemente (13) mindestens vier um den Umfang des Heizelements (2; 5; 6) gleichmäßig verteilte Zuganker vorgesehen sind.

14. Widerstandsofen nach einem der vorhergehenden Ansprüche, **dadurch gekennzeichnet, dass** der Gaseinlass (19) in mindestens drei Verzweigungsstufen (82; 83; 85) mit gleichem Druckverlust verzweigt.

15. Widerstandsofen nach Anspruch 1, **dadurch gekennzeichnet, dass** die Gasauslässe (86) in einem oberhalb der oberen Ringmanschette (7) angeordneten Spülring (18) ausgebildet sind, der sich aus mindestens zwei - vorzugsweise aus mindestens vier - separaten Kreissegmenten (89) zusammensetzt, wobei die Nebenleitungen (20) jeweils in eines der Kreissegmente (89) münden.

16. Widerstandsofen nach einem der vorhergehenden Ansprüche, **dadurch gekennzeichnet, dass** das Heizelement (2; 5; 6) von einem temperierbaren Schutzmantel (21) umgeben ist, an dessen Außenwandung Kühlplatten (29) lösbar befestigt sind, innerhalb denen eine Kühlflüssigkeit fließt.

17. Widerstandsofen nach einem der vorhergehenden Ansprüche, **dadurch gekennzeichnet, dass** das Innere des Heizelements (2; 5; 6) mittels Quarzwolle (26) nach außen abgedichtet ist.

18. Widerstandsofen nach Anspruch 17, **dadurch gekennzeichnet, dass** die Quarzwolle (26) aus synthetisch hergestelltem SiO₂ besteht.

## Claims

1. A resistance furnace comprising a tubular heating element having a vertically oriented longitudinal axis, said heating element having a shell surface defined by an upper side and a lower side and surrounding a furnace chamber, and being connected to at least two supply terminals by means of which heating current is introduced at power supply points into said heating element, said supply terminals comprise a surrounding upper annular collar (7) adjacent said upper side (11) and a surrounding lower annular collar (8) adjacent said lower side (12) **characterized in that** gas flushing is provided by a system which comprises a gas inlet (19) which is branched in at least one branch stage (82) into a plurality of secondary lines (20), said secondary lines (20) terminating in a plurality of gas outlets (86) which are uniformly distributed over an envelope circle and directed into said furnace chamber (4).

2. The resistance furnace according to claim 1, **characterized in that** each of said annular collars (7; 8) comprises an electrode terminal (71) for feeding said heating current, and wherein said electrode terminal (71) of said upper annular collar (7) is offset circumferentially relative to said electrode terminal of said lower annular collar (8).

3. The resistance furnace according to claim 1 or 2, **characterized in that** each of said annular collars (7; 8) is provided with at least two electrode terminals (71; 72) uniformly distributed circumferentially around said annular collar (7; 8).

4. The resistance furnace according to any one of the preceding claims, **characterized in that** regions (73) of lower electrical conductivity are formed in said annular collar (7; 8) for branching the supplied heating current into at least four, preferably into at least eight, current paths (77) leading to favored power supply points (76) uniformly distributed over the circumference of said heating element (2; 5; 6).

5. The resistance furnace according to claim 4, **characterized in that** said power supply points (76) of said upper annular collar (7) are offset circumferentially relative to said power supply points of said lower annular collar (8).

6. The resistance furnace according to any one of the preceding claims, **characterized in that** said annular collars (7; 8) comprise a connection cone matching a conical connection region of said heating element (2; 5; 6).

7. The resistance furnace according to claim 6, **characterized in that** said connection cone is an inner cone and the connection region of said heating element (2; 5; 6) is an outer cone.

8. The resistance furnace according to any one of the preceding claims, **characterized in that** said annular collars (7; 8) have a first surrounding cooling channel (9) having a first coolant inlet (27).

9. The resistance furnace according to claim 8, **characterized in that** said annular collars (7; 8) have a second surrounding cooling channel adjacent said first cooling channel (9) and spatially separated therefrom, said second surrounding cooling channel (10) having a second coolant inlet (28), said second coolant inlet (28) arranged at the side of said annular collar (7; 8) circumferentially opposite said first inlet (27).

10. The resistance furnace according to any one of the preceding claims, **characterized in that** said annular collars (7; 8) consist of copper or a copper alloy.

11. The resistance furnace according to any one of the preceding claims, **characterized in that** said heating element (2; 5; 6) comprises a heating tube (2) having a smaller wall thickness, said heating tube being extended at both sides by means of at least one contact tube (5; 6) following at the front side and having a greater wall thickness, each of said annular collars (7; 8) being supported on said contact tube (5; 6).

12. The resistance furnace according to claim 11, **characterized in that** there is provided a clamping means which comprises a plurality of clamping elements (13) by means of which said contact tubes (5; 6), said heating tube (2) and said annular collars (7; 8) are axially clamped relative to one another.

13. The resistance furnace according to claim 12, **characterized in that** at least four tension rods which are uniformly distributed over the circumference of said heating element (2; 5; 6) are provided as clamping elements (13).

14. The resistance furnace according to any one of the preceding claims, **characterized in that** the gas inlet (19) is branched in at least three branch stages (82; 83; 85) of equal pressure loss.

15. The resistance furnace according to claim 14, **characterized in that** said gas outlets (86) are formed in a flush ring (18) which is arranged above said upper annular collar (7) and is composed of at least two, preferably at least four, separate circular segments (89), said secondary lines (20) each terminating in one of said circular segments (89).

16. The resistance furnace according to any one of the preceding claims, **characterized in that** said heating element (2; 5; 6) is surrounded by a protective jacket (21) of a controllable temperature whose outer wall has detachably secured thereto cooling plates (29) within which a cooling liquid is flowing.

17. The resistance furnace according to any one of the preceding claims, **characterized in that** the interior of said heating element (2; 5; 6) is sealed to the outside by means of quartz wool (26).

18. The resistance furnace according to claim 18, **characterized in that** said quartz wool (26) consists of synthetically produced SiO₂.

## Revendications

1. Four à résistance, comprenant un élément de chauffage tubulaire avec un axe longitudinal orienté verticalement qui présente une surface d'enveloppe limitée par une face supérieure et une face inférieure, qui entoure une enceinte de four et qui est reliée à au moins deux raccords électriques, au moyen desquels le courant de chauffage est introduit dans l'élément de chauffage aux postes d'alimentation électrique, les raccordements électriques présentant une manchette annulaire supérieure (7), circulaire dans la zone de la face supérieure (11 et une manchette annulaire inférieure (8) circulaire dans la zone de la face inférieure (12), **caractérisé en ce qu'**un dispositif est prévu pour un barbotage qui présente une entrée de gaz (19) qui est ramifiée dans au moins un niveau de ramification (82) plusieurs conduites auxiliaire(20), les conduites auxiliaires (20) débouchant dans un grand nombre de sorties de gaz (86) qui sont réparties régulièrement autour d'un cercle d'enveloppe et sont dirigées vers l'intérieur de l'enceinte de four (4).

2. Four à résistance selon la revendication 1, **caractérisé en ce que** chaque manchette circulaire (7; 8) présente un raccordement d'électrode (71) pour l'alimentation du courant de chauffage et **en ce que**, vu dans la direction périphérique, le raccordement d'électrode (71) de la manchette annulaire supérieure (7) est disposé de manière décalée par rapport au raccordement d'électrode de la machette annulaire inférieure (8).

3. Four à résistance selon la revendication 1 ou 2, **caractérisé en ce que** chaque manchette annulaire (7; 8) est munie d'au moins deux raccordements d'électrodes (71; 72) répartis régulièrement dans le sens périphérique autour de la manchette annulaire (7; 8).

4. Four à résistance selon l'une des revendications précédentes, **caractérisé en ce que** la manchette annulaire (7; 8) présente des zones (73) de conductibilité électrique plus faible, au moyen desquels le courant de chauffage alimenté est ramifié dans au moins quatre de préférence dans au moins huit passages de courant (77) qui amène aux points d'alimentation de courant (76) favorisés, distribuées régulièrement sur la périphérie de l'élément de chauffage (2; 5; 6).

5. Four à résistance selon la revendication 4, **caractérisé en ce que** - vu dans la direction périphérique - les postes d'alimentation de courant (76) de la manchette annulaire supérieure (7) sont disposés en décalé par rapport aux points d'alimentations de courant de la manchette annulaire inférieure (8).

6. Four à résistance selon l'une des revendications précédentes, **caractérisé en ce que** la manchette annulaire (7; 8) présente un cône de raccordement qui correspond à une zone conique de raccordement de l'élément de chauffage (2; 5; 6).

7. Four à résistance selon la revendication 6, **caractérisé en ce que** le cône de raccordement en tant que cône interne et la zone de raccordement de l'élément de chauffage (2; 5; 6) sont réalisés comme cône externe.

8. Four à résistance selon l'une des revendications précédentes, **caractérisé en ce que** les manchettes annulaires (7; 8) présentent un premier canal de refroidissement circulaire (9) qui est muni d'une première entrée de réfrigérant (27).

9. Four à résistance selon la revendication 8, **caractérisé en ce que** les manchettes annulaires (7; 8) présentent au voisinage du premier canal de refroidissement (9) et séparé spatialement de ce dernier un second canal de refroidissement circulaire (10) muni d'une seconde entrée de réfrigérant (28), la seconde entrée (28) - vu dans la direction périphérique - étant disposée sur la face de la manchette annulaire (7; 8) qui est opposée à la première (27).

10. Four à résistance selon l'une des revendications précédentes, **caractérisé en ce que** les manchettes annulaires (7; 8) se composent de cuivre ou d'alliage de cuivre.

11. Four à résistance selon l'une des revendications précédentes, **caractérisé en ce que** l'élément de chauffage (2; 5; 6) comprend un tube de chauffage (2) avec une épaisseur de paroi plus mince qui est prolongé des deux côtés au moyen d'au moins un tube de contact (5; 6) se trouvant dans la continuité avec une épaisseur de paroi plus épaisse. les manchettes annulaires (7; 8) s'appliquant respectivement contre le tube de contact (5; 6).

12. Four à résistance selon la revendication 11, **caractérisé en ce qu'**il est prévu un dispositif de serrage qui comprend plusieurs éléments de serrage (13) au moyen desquels les tubes de contact (5; 6), le tube de chauffage (2) et les manchettes annulaires (7; 8) sont serrés les uns envers les autres dans la direction axiale.

13. Fours à résistance selon la revendication 12, **caractérisé en ce qu'**en tant qu'élément de serrage (13), il est prévu au moins quatre tirants d'ancrage répartis régulièrement autour de la périphérie de l'élément de chauffage (2; 5; 6).

14. Four à résistance selon l'une des revendications précédentes, **caractérisé en ce que** l'entrée de gaz (19) se ramifie dans au moins trois niveaux de ramifications (82, 83; 85) avec une perte de pression.

15. Four à résistance selon la revendication 1, **caractérisé en ce que** les sorties de gaz (86) sont réalisées dans un anneau de barbotage (18) disposé au-dessus de la manchette annulaire supérieure (7), anneau qui se compose d'au moins deux de préférence quatre segments de cercle séparés (89), les conduites auxiliaires (20) débouchant respectivement dans l'un des segments de cercle (89).

16. Four à résistance selon l'une des revendications précédentes, **caractérisé en ce que** l'élément de chauffage (2; 5; 6) est entouré par une enveloppe de protection tempérable (21) à la paroi externe de laquelle des plaques de refroidissement (29) sont fixées de manière visible à l'intérieur desquelles s'écoule un liquide de refroidissement.

17. Four à résistance selon l'une des revendications précédentes, **caractérisé en ce que** l'élément de chauffage (2; 5; 6) est étanchéifié vers l'extérieur par de la laine de verre (26).

18. Four à résistance selon la revendication 17, **caractérisé en ce que** la laine de verre se compose de SiO2 fabriqué synthétiquement.
